Europäisches Patentamt

European Patent Office

Office européen des brevets

(19)

(11) **EP 0 928 498 B1**

(12) **EUROPÄISCHE PATENTSCHRIFT**

(45) Veröffentlichungstag und Bekanntmachung des Hinweises auf die Patenterteilung:
**30.08.2000 Patentblatt 2000/35**

(21) Anmeldenummer: **97951255.5**

(22) Anmeldetag: **20.11.1997**

(51) Int Cl.[7]: **H01L 21/285**, C23C 16/30, C23C 16/34, C23C 16/56, H01L 21/3205

(86) Internationale Anmeldenummer:
**PCT/EP97/06497**

(87) Internationale Veröffentlichungsnummer:
**WO 98/24117 (04.06.1998 Gazette 1998/22)**

(54) **VERFAHREN ZUM ERZEUGEN EINER TITANMONOPHOSPHIDSCHICHT UND IHRE VERWENDUNG**

METHOD FOR PRODUCING A TITANIUM MONOPHOSPHIDE LAYER AND ITS USE

PROCEDE DE PRODUCTION D'UNE COUCHE DE MONOPHOSPHURE DE TITANE ET UTILISATION DE CELLE-CI

(84) Benannte Vertragsstaaten:
**BE DE FR GB**

(30) Priorität: **29.11.1996 DE 19649684**

(43) Veröffentlichungstag der Anmeldung:
**14.07.1999 Patentblatt 1999/28**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
• **FRÖSCHLE, Barbara**
  **D-89160 Dornstadt (DE)**
• **LEUTENECKER, Roland**
  **D-85259 Wiedenzhausen (DE)**
• **RAMM, Peter**
  **D-85276 Pfaffenhofen (DE)**

(74) Vertreter: **Schoppe, Fritz, Dipl.-Ing. et al**
**Schoppe, Zimmermann & Stöckeler Patentanwälte**
**Postfach 71 08 67**
**81458 München (DE)**

(56) Entgegenhaltungen:
• **LEUTENECKER R ET AL: "Titanium monophosphide (TiP) layers as potential diffusion barriers" SECOND EUROPEAN WORKSHOP ON MATERIALS FOR ADVANCED METALLIZATION. MAM'97, VILLARD DE LANS, FRANCE, 16-19 MARCH 1997, Bd. 37-38, ISSN 0167-9317, MICROELECTRONIC ENGINEERING, NOV. 1997, ELSEVIER, NETHERLANDS, Seiten 397-402, XP002060930**
• **CHEMISTRY OF MATERIALS LEWKEBANDARA T S ET AL: 'PRECURSOR FOR THE LOW-TEMPERATURE DEPOSITION OF TITANIUM PHOSPHIDE FILMS' Bd. 7, Nr. 6, 01 Juni 1995,, Seiten 1053 - 1054, XP000513073**
• **DATABASE INSPEC INSTITUTE OF ELECTRICAL ENGINEERS, STEVENAGE, GB Inspec No. 4074008, LA VIA F ET AL: "Rapid thermal processing reliability of titanium silicide implanted with arsenic, boron and phosphorus" XP002060933 & 1991 EUROPEAN WORKSHOP ON REFRACTORY METALS AND SILICIDES, SALTSJOBADEN, SWEDEN, 24-27 MARCH 1991, Bd. 53, ISSN 0169-4332, APPLIED SURFACE SCIENCE, 1991, NETHERLANDS, Seiten 377-382**

- CHEMICAL ABSTRACTS, vol. 101, no. 4, 23.Juli 1984 Columbus, Ohio, US; abstract no. 32381, XP002060931 & Y. SASAKI, M. HIROHASHI: "Composition of phosphide films formed by titanium - phosphorus reaction and the diffusing species" DENKI KAGAKU OYOBI KOGYO BUTSURI KAGAKU, Bd. 52, Nr. 3, 1984, Seiten 203-204

- CHEMICAL ABSTRACTS, vol. 115, no. 16, 21.Oktober 1991 Columbus, Ohio, US; abstract no. 164194, XP002060932 & E. KOLAWA, P. POKELA, L. E. HALPERIN, Q. YU, M. A. NICOLET: "Amorphous ternary thin- film alloys as diffusion barriers in silicon metallizations" NEW TECHNOL. ELECTRON. PACKAG., PROC. ASM INT. ELECTRON MATER. PROCESS. CONGR. , Nr. 3, 1990, OHIO, Seiten 243-247

**Beschreibung**

Die vorliegende Erfindung bezieht sich auf ein Verfahren zum Erzeugen einer Titanmonophosphid-Schicht auf einer Titannitrid-Schicht. Die vorliegende Erfindung bezieht sich insbesondere auf ein derartiges Verfahren, das während der Erzeugung einer Mehrlagenmetallisierung auf einem Halbleitermaterial verwendet werden kann.

Es ist bekannt, Titanmonophosphid, TiP, bei Temperaturen im Bereich von 1000°C in Anwesenheit von Katalysatoren wie Au, Pt oder Pd abzuscheiden. Der niedrigste beschriebene Temperaturwert zur Erzeugung von Titanphosphiden beträgt dabei 750°C.

Eine derartige Bildung von TiP ist beispielsweise bei S. Motojima, T. Wakamatsu, Y. Takahashi und K. Sugiyama, J. Electrochem. Soc., 123 (1976), 290, beschrieben. In der genannten Schrift ist die Whiskerbildung von Titanphosphiden beschrieben. Dabei erfolgte die Bildung von Titanmonophosphid aus $TiCl_4$ und $PCl_3$ bei Temperaturen von 850°C bis 1150°C auf Katalysatoren wie Pt, Pd und Au. Die Abscheidung dünner Schichten aus TiP ist in dieser Schrift nicht offenbart.

Es ist auf dem Gebiet der Halbleitertechnologie allgemein bekannt, Diffusionsbarrieren zwischen Silizium und einer Aluminium-Metallisierung durch reaktives Sputtern von Titannitrid (TiN) zu erzeugen. Typische Schichtdicken des Titannitrids liegen bei 50 nm. Der Nachteil des Sputterns ist die schlechte Kantenbedeckung, besonders in schmalen und tief geätzten Strukturen. CVD-Verfahren (CVD = chemical vapour deposition = chemische Dampfabscheidung) liefern eine bessere Kantenbedeckung.

Alternativ zu einer Abscheidung der oben genannten Art sind Verfahren zur Bildung von Titannitrid bekannt, die auf der Zersetzung von metallorganischen Prekursoren, die bereits Ti-N-Komplexe enthalten, basieren. Ferner ist das Abscheiden von Titannitrid unter Verwendung von Titantetrachlorid ($TiCl_4$) und Ammoniak ($NH_3$) bekannt. Bei der Zersetzung von metallorganischen Prekursoren ist die hohe Kohlenstoffkonzentration, die mit eingebaut wird, problematisch. Bei der Abscheidung einer Titannitrid-Schicht unter Verwendung von $TiCl_4$ und $NH_3$ ist der Einbau von Chlor problematisch, der den spezifischen Widerstand der Barriere erhöht und zu einer Korrosion von Aluminium führen kann. Ferner sind bei der Mehrlagenmetallisierung auf einem Halbleiter nur Temperaturen bis 450°C zulässig. Die $TiCl_4/NH_3$-Reaktion liefert aber erst ab Temperaturen von > 550°C Schichten mit einer kritischen Cl-Konzentration unter 2 at%.

Um die bei dem $TiCl_4/NH_3$-Prozeß bei 450°C erzeugte, zu hohe Chlorkonzentration in der Titannitrid-Schicht abzusenken, ist es bekannt, die eingebauten Verunreinigungen an Cl-Atomen und nicht vollständig reagierte Fragmente der Prekursoren ("$TiN_xCl_y$") anschließend durch eine ("in-situ")-Temperung zu reduzieren. Der spezifische Widerstand der Titannitrid-Schichten korreliert mit der Chlorkonzentration, wobei der Restchlorgehalt ein Maß für die Vollständigkeit der Reaktion ist. Als Tempergas zur Extraktion von Chlor ist das Reaktivgas $NH_3$ bekannt. Durch die Temperung der Titannitrid-Schicht unter Verwendung von $NH_3$ bei 450°C und einer Dauer von 120 Sekunden kann der Cl-Gehalt auf < 2 at% gesenkt werden. Der spezifische Widerstand dieser getemperten Schichten liegt auf einem Wert von < 300 µΩcm. Er ist damit erheblich niedriger als bei Schichten, die mit herkömmlicher CVD und entsprechender Temperatur abgeschieden wurden.

Als Mechanismus zur Extraktion von Chlor bei der oben genannten Reaktivgastemperung verschiebt $NH_3$ das Reaktionsgleichgewicht der Gesamtreaktion

$$6\ TiCl_4 + 8\ NH_3 \rightarrow 6TiN + 24\ HCl + N_2$$

unter hohem $NH_3$-Angebot in Richtung der Endprodukte TiN + HCl.

In dem Artikel "Precursor for the low-temperature deposition of titanium phosphide films" von T.S. Lewkebandara u.a. in: Chemistry of Materials, Bd. 7, Nr. 6, 1.6.1995, Washington, US, Seiten 1053 und 1054, ist die Abscheidung eines TiP-Films auf einem Substrat aus Glas oder Silizium beschrieben. Hierzu wird die Verwendung einer chemischen Abscheidung aus der Gasphase bei niedrigem Druck (LPCVD) unter Verwendung eines Komplexes aus Titantetrachlorid und Cyclohexylphosphin gelehrt. Ferner erwähnt der genannte Artikel die Abscheidung von $TiCl_4$ und $PCl_3$.

In Chemical Abstracts, Bd. 115, Nr. 16, 21.10.1991, Columbus, Ohio, US, Abstract Nr. 164194 & New Technol. Electron. Packag., Proc. ASM Int. Electron. Mater. Process. Congr., Nr. 3 (1990), Ohio, US, Seiten 243 -347, E. Kolawa u.a.: "Amorphous ternary thin-film alloys as diffusion barriers in silicon metallizations", ist die Herstellung einer dünnen Barriereschicht aus $TiPN_2$ mit Hilfe eines Sputterverfahrens beschrieben.

Ausgehend von dem genannten Stand der Technik besteht die Aufgabe der vorliegenden Erfindung darin, ein Verfahren zum Erzeugen einer Titanmonophosphid-Schicht auf einer Titannitrid-Schicht zu schaffen.

Diese Aufgabe wird durch ein Verfahren gemäß Anspruch 1 gelöst.

Eine weitere Aufgabe der vorliegenden Erfindung besteht darin, Diffusionsbarriereschichten mit verbesserten Eigenschaften zwischen einem Halbleitermaterial, einem Dielektrikum oder einem Ferroelektrikum und einer aufgebrachten Metallisierung zu schaffen.

Diese Aufgabe wird durch Diffusionsbarriereschicht gemäß Anspruch 9 gelöst.

Die vorliegende Erfindung basiert auf der Erkenntnis, daß auf einer Titannitrid-Schicht (TiN-Schicht) eine Titanmonophosphid-Schicht (TiP-Schicht) gebildet werden kann, wenn eine durch einen konventionellen Prozeß mit Titantetrachlorid und Ammoniak abgeschiedene TiN-Schicht unmittelbar nach der Abscheidung in dem gleichen Reaktor einer Temperung unter Zuführung von Phosphin (PH$_3$) unterzogen wird. Phosphin wirkt als Spender für Wasserstoff und somit Getter für Cl aktiver als NH$_3$ (PH$_3$: ..G$_f$ = 13,6 kJ/mol; NH$_3$: ..G$_f$ = -16,4 kJ/mol). Gleichzeitig kann Phosphin als Getter für Sauerstoff dienen.

Die vorliegende Erfindung schafft ein Verfahren zum Erzeugen einer Titanmonophosphid-Schicht, bei dem zunächst ein Träger in einen Reaktor eingebracht wird. Nachfolgend wird auf dem Träger durch die Zuführung von TiCl$_4$ und NH$_3$ in den Reaktor eine TiN-Schicht abgeschieden. Die TiN-Schicht wird unmittelbar nach dem Abscheiden der TiN-Schicht in dem Reaktor einer Temperung unter Zuführung von PH$_3$ unterworfen, um auf der TiN-Schicht eine TiP-Schicht zu bilden.

Folglich basiert die vorliegende Erfindung darauf, daß durch die Temperung von Schichten aus Titannitrid in Phosphin vorzugsweise bei 450°C Deckschichten aus reinem Titanmonophosphid deponiert werden können. Die Phase TiP sowie der Schichtaufbau als Doppelschicht können eindeutig beispielsweise mittels Röntgendiffraktometern oder mittels der Auger-Elektronenspektroskopie identifiziert werden. Vorzugsweise werden die TiN-Schichten mittels eines RTCVD-Prozesses (RTCVD = Rapid Thermal Chemical Vapour Deposition) unter Verwendung von Titantetrachlorid und Ammoniak auf Silizium-Wafern abgeschieden. Die Temperung der Scheiben in PH$_3$ erfolgt dann unmittelbar anschließend in dem gleichen Reaktor.

Das erfindungsgemäße Verfahren kann vorteilhaft in der Halbleitertechnologie angewendet werden, um eine Diffusionsbarriereschicht zwischen einem Halbleitermaterial, beispielsweise Silizium, und einer Metallisierung, beispielsweise Aluminium, zu bilden. Die Diffusionsbarriere besteht dann aus einer Doppelschicht, die aus TiN und TiP besteht.

Die vorliegende Erfindung schafft demnach gemäß einem weiteren Aspekt eine Diffusionsbarriereschicht zwischen einem Halbleitermaterial und einer auf dasselbe aufgebrachte Metallisierung, wobei die Diffusionsbarriereschicht aus einer Doppelschicht besteht, die eine TiN-Schicht und eine TiP-Schicht aufweist. Eine solche Diffusionsbarriereschicht weist gegenüber einer herkömmlichen Diffusionsbarriereschicht, die aus TiN besteht, zahlreiche Vorteile auf.

Die erzeugte TiP-Auflageschicht weist einen verglichen mit TiN sehr geringen spezifischen Widerstand auf. Sie dichtet ferner die gesamte TiN-Schicht gegen die Aufnahme von Sauerstoff ab. Die Rauhigkeit von TiP ist geringer als die von TiN. Ferner sind die Zugspannungen in der TiP-Auflageschicht gering im Vergleich zu getemperten TiN-Schichten.

Weiterbildungen der vorliegenden Erfindung sind in den abhängigen Ansprüchen dargelegt.

Bevorzugte Ausführungsbeispiele der vorliegenden Erfindung werden nachfolgend bezugnehmend auf die beiliegenden Zeichnungen näher erläutert. Es zeigen:

Fig. 1    eine schematische Darstellung des Aufbaus eines Reaktors; und

Fig. 2    eine Darstellung von mittels einer Auger-Elektronenspektroskopie aufgenommenen Tiefenprofilen an einer TiP/TiN-Doppelschicht.

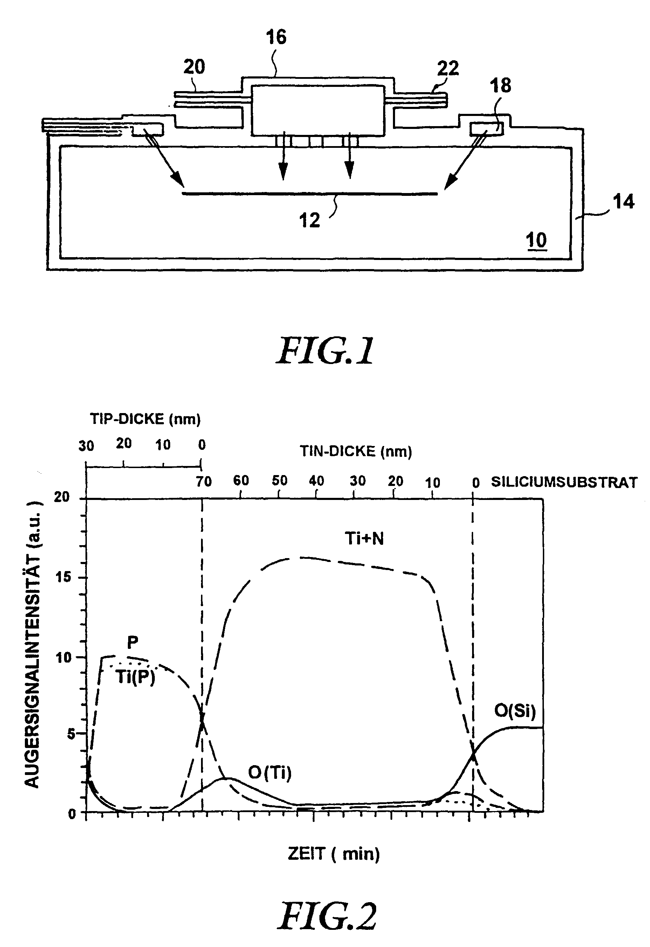

Bezugnehmend auf Fig. 1 wird nachfolgend ein Reaktor, der zum Durchführen des erfindungsgemäßen Verfahrens geeignet ist, erläutert. Ein solcher Reaktor wird auch als RTP-Anlage (RTP = Rapid Thermal Processing) bezeichnet.

Der Reaktor besteht aus einem im wesentlichen geschlossenen Innenraum 10, der eine Mehrzahl von Eingängen aufweist. Der Reaktor 10 weist ferner eine Haltestruktur, in Fig. 1 nicht dargestellt, zum Aufnehmen eines zu bearbeitenden Halbleiters, beispielsweise eines Siliziumsubstrats 12, auf. Der Reaktor weist ferner einen Lampenheizer und ein Quarzfenster auf, wobei das Siliziumsubstrat 12 mittels des Lampenheizers durch das Quarzfenster auf Prozeßtemperatur beheizt werden kann. Die Solltemperatur wird dabei in einigen 10 Sekunden erreicht. Der Heizer kann beispielsweise aus Halogen-Stablampen bestehen, die von einem Reflektor umgeben sind. Derartige Halogen-Stablampen können eine maximale Heizleistung von 72 kW aufweisen. Das Reaktorgefäß 14 besteht bei bekannten Reaktoren aus Edelstahl.

In dem Reaktorgefäß 14 sind zwei getrennte Gaszuführungssysteme angeordnet. Ein erstes Gaszuführungssystem 16, das eine in der Technik allgemein als Gasdusche bekannte Vorrichtung sein kann, dient dazu, ein Gas von oben zu dem Siliziumsubstrat 12 strömen zu lassen. Die Gasdusche 16 dient ferner dazu, um über eine Druckstufe Reaktionen in einer Zuleitung zu verhindern. Ein weiteres Gaszuführungssystem 18 wird als Ringkanal bezeichnet und kann beispielsweise zwölf schräg nach unten direkt auf das Siliziumsubstrat 12 gerichtete Düsen aufweisen.

Gemäß dem erfindungsgemäßen Verfahren wird zunächst das Siliziumsubstrat 12 durch eine Einbringöffnung, nicht dargestellt, in den Innenraum 10 des Reaktorgefäßes 14 eingebracht. Die Kammerwände und das oben beschriebene Quarzfenster werden auf knapp 60°C beheizt, um eine Kondensation von TiCl$_4$ zu verhindern. Das TiCl$_4$ wird verdünnt in einem N$_2$-Trägergas über die Gasdusche 16 eingebracht, wobei TiCl$_4$ über eine Zuleitung 20 und N$_2$ über eine Zuleitung 22 der Gasdusche zugeführt wird. Das NH$_3$ wird ebenfalls verdünnt in N$_2$ über die Ringleitung 18 und die Düsen derselben in das Reaktorgefäß eingebracht. Die beiden Substanzen TiCl$_4$ und NH$_3$ werden erst kurz über dem Siliziumsubstrat 12 gemischt, da diese bereits bei Raumtemperatur reagieren.

Durch die oben beschriebenen Schritte wird auf dem Siliziumsubstrat 12 in bekannter Weise eine TiN-Schicht abgeschieden. Ist das Abscheiden der TiN-Schicht abgeschlossen, wird unmittelbar nachfolgend über die Ringleitung 18 $PH_3$ verdünnt in Argon in das Reaktorgefäß zugeführt. Dadurch bildet sich auf der TiN-Schicht eine TiP-Schicht. Mit diesem Schritt ist das erfindungsgemäße Verfahren abgeschlossen.

Bevorzugte Prozeßparameter zur Abscheidung von TiP/TiN-Doppelschichten gemäß der vorliegenden Erfindung werden im Folgenden erläutert. Der Träger, d.h. bei dem bevorzugten Ausführungsbeispiel das Siliziumsubstrat 12, wird vorzugsweise auf eine Temperatur von 450°C erwärmt. Dies ist die maximale Temperatur, die bei einer Mehrlagenmetallisierung auf Halbleitern zulässig ist. Der Basisdruck in dem Reaktorgefäß wird auf einen Wert zwischen 0,5 x $10^{-3}$ bis 5 x $10^{-3}$ Pascal, und vorzugsweise auf einen Wert von 2 x $10^{-3}$ Pascal eingestellt.

Zur TiN-Abscheidung wurden bei dem verwendeten Reaktor, bei dem es sich um einen Reaktor des Typs "Jetlight 200" der Firma Jipelec handelte, folgende Flüsse verwendet: 5 sccm $TiCl_4$ mit 400 sccm $N_2$ als Verdünnung. (sccm = Standardkubikzentimeter pro Minute bei Raumtemperatur und Normaldruck); 50 sccm $NH_3$ mit 350 sccm $N_2$ als Verdünnung.

Vorzugsweise wird zur Abscheidung der TiN-Schicht ein Verhältnis von $TiCl_4$ zu $N_2$ zwischen 1:60 und 1:100 verwendet. Ein spezifisches bevorzugtes Verhältnis ist 1:80. Das Verhältnis von $NH_3$ zu $N_2$ wird vorzugsweise zwischen 1:5 und 1:9 eingestellt, wobei ein spezifisches bevorzugtes Verhältnis 1:7 beträgt.

Das Abscheiden der TiN-Schicht wurde somit in dem oben beschriebenen bekannten Reaktor mit einem Gesamtfluß von 805 sccm bei einem Druck von 400 Pa und einer Abscheidezeit von 180 Sekunden durchgeführt.

Die Temperung der TiN-Schicht erfolgte nachfolgend unter Zuführung eines Flusses von 130 sccm $PH_3$ mit 750 sccm Argon als Verdünnung. Dieses Gemisch wird vorgemischt durch die Ringleitung 18 zugeführt. Es wurde folglich ein Gesamtfluß von 880 sccm bei einem Druck von 250 Pa und einer Temperzeit von 600 Sekunden verwendet.

Ein bevorzugter Bereich für das Verhältnis von $PH_3$ und Argon bei der Temperung liegt zwischen 1:3 und 1:8. Bei dem oben beschriebenen Verfahren wurde ein Verhältnis von 1:5,77 verwendet.

Da die Temperung der TiN-Schicht unter Verwendung von $PH_3$ unmittelbar nach dem Abscheiden der TiN-Schicht in dem gleichen Reaktor durchgeführt wird, sind in dem Reaktor noch unreagierte und nicht vollständig dissoziierte Reste des Prekursors $TiCl_4$ vorhanden. Von dem klassischen $TiCl_4/NH_3$-Prozeß her ist bekannt, daß sich bei diesem Prozeß stets Addukte des Typs $TiCl_4$ * $xNH_3$ (x = 2, 4, 6, 8) bilden, die an den Reaktorwänden adsorbieren. Bei der Niedertemperaturabscheidung bei oder unter 450°C sind auch auf der Scheibenoberfläche noch nicht vollständig umgesetzte Reste des Prekursors in Form von $TiN_xCl_y$ vorhanden, die nachreagieren können. Diese Oberfläche kann, solange sie nicht oxidiert ist, eine katalytische Wirkung aufweisen, um die Bildung von TiP zu unterstützen und/oder einzuleiten. Zur Umsetzung dieser unreagierten oder unvollständig umgewandelten Ausgangssubstanzen zu TiP ist eine hohe Konzentration von $PH_3$ im Verhältnis zum Angebot der $TiCl_4$-Komponente vorteilhaft. Der maximal erreichbare Fluß an $PH_3$ beträgt 130 sccm. Bei diesem Fluß ist das Wachstum von TiP über der Scheibe noch nicht homogen, sondern hängt von der Anströmung von $PH_3$ aus den Düsen des Ringkanals ab. Die Reaktion ist folglich noch transportkontrolliert. Im Gegensatz dazu ergibt sich beim bekannten Tempern unter der Zuführung von $NH_3$, bei der ein höherer Gesamtfluß von 600 sccm möglich ist, ein homogenes Nachwachsen während der Temperung.

Fig. 2 zeigt die Tiefenprofile der mittels des erfindungsgemäßen Verfahrens erhaltenen TiP/TiN-Doppelschicht, aufgenommen mittels einer Auger-Elektronenspektroskopie. Aus der Kombination von integralen Flächenbelegungen der Elemente Ti, P und N (RBS; RBS = Rutherford Back Scattering) und der Auger-Elektronenspektroskopie-Tiefenprofile ergibt sich, daß während des Temperns auf TiN eine zusätzliche Schicht mit der Stöchiometrie Ti:P = 1:1 aufgewachsen wird. Auf der in Fig. 2 dargestellten Zeitskala zeigen die größeren Einteilungen jeweils 5 Minuten an, während die kleineren Einteilungen jeweils 1 Minute anzeigen. Bei dem erfindungsgemäßen Verfahren verläuft die Zeitachse von rechts nach links, d.h. zunächst wird die TiN-Schicht aufgebracht, während nachfolgend die TiP-Schicht aufgebracht wird. Bei einer Temperzeit von 600 Sekunden und den Verfahrensparametern, die oben erläutert wurden, beträgt die resultierende Dicke der TiP-Schicht etwa 30 nm. Die erzeugte TiP-Phase ist im Gegensatz zu TiN polykristallin (<100>-Textur). Die Bildungsentalpie von TiP weist mit $\Delta G_f$ = -265 kJ/mol eine vergleichbare Größe auf wie die von TiN (-310 kJ/mol).

Die mittels des erfindungsgemäßen Verfahrens erzeugte TiP/TiN-Doppelschicht weist als Diffusionsbarriere zwischen einem Halbleiter und einer Metallisierung hervorragende Eigenschaften auf.

Der spezifische Widerstand des abgeschiedenen TiP liegt bei 20 μΩcm. Ein Vergleich mit den TiN-Schichten, deren spezifischer Widerstand bei 200 bis 300 μΩcm liegt, und Aluminium, 2,7 μΩcm, verdeutlicht, daß es sich bei dem erzeugten TiP um einen guten elektrischen Leiter handelt. Ferner ist die TiP-Schicht selbst Cl-frei, während die darunterliegende TiN-Schicht nach der Temperung wie bei der $NH_3$-Temperung Cl-Werte < 2 at% aufweist. Durch das Tempern unter Zuführung von $PH_3$ wird Cl rasch aus der vordeponierten TiN-Schicht entfernt.

Die erzeugte TiP-Schicht weist ein dünnes Deckoxid auf, ist aber im Gegensatz zur TiN-Schicht selbst O-frei. Die TiP-Schicht stellt eine Versiegelung dar, da dieselbe während der Temperung und während der Lagerung an Luft keinen Sauerstoff aufnimmt. Die Begründung dafür ist, daß die Körner der TiN-Schicht kolumnar sind, wobei ihre Breite nur 5 bis 10% ihrer Länge beträgt. Dagegen sind die Körner der TiP-Schicht polyedrisch, wobei ihr Durchmesser sowohl in der Schichtebene als auch senkrecht dazu in der Größenordnung der Schichtdicke liegt. TiN ist aufgrund der kolumnaren Struktur porös, während zwischen den TiP-Körnern keine Kanäle vorliegen.

Die TiP-Schicht gleicht die Rauhigkeit des kolumnaren TiN teilweise aus und macht sie langwelliger. Dadurch liefert die TiP-Schicht eine Oberfläche mit einer gegenüber einer TiN-Schicht verringerten Rauhigkeit. Eine gemäß dem Stand der Technik getemperte TiN-Schicht weist Zugspannungen von 2 bis 3 GPa auf, während die TiP-Schicht gemäß der vorliegenden Erfindung maximal eine Zugspannung von 1 GPa aufweist. Dadurch kann die TiP-Schicht eine bessere mechanische Anpassung von Barriere und beispielsweise Al-Metallisierung liefern. Ferner ist TiP thermisch sehr stabil gegen den Verlust von Phosphor, weshalb verhindert ist, daß Phosphor in den verwendeten Halbleiter, bei dem bevorzugten Ausführungsbeispiel Silizium, diffundiert und dotierend wirkt.

Die erfindungsgemäße Titanmonophosphidschicht kann ferner vorteilhaft bei Ferroelektrika-Bauelementen verwendet werden. Diesbezüglich besteht eine weitere wichtige Anwendung von TiP bei der Herstellung von DRAMs (DRAM = dynamic random access memory = dynamischer Direktzugriffspeicher) mit Dielektrika oder Ferroelektrika mit hoher elektrischer Dielektrizitätskonstante (sogenannten High-Epsilon-Dielektrika bzw. -Ferroelektrika) zu sehen.

Der Aufbau einer derartigen Struktur besteht aus einer Poly-Silizium-Kontaktschicht mit einer Diffusionsbarriere zu einer Speicherelektrode, die beispielsweise aus $RuO_2$ besteht. Diese Diffusionsbarriere muß sowohl gegen eine Metalldiffusion als auch gegen eine Sauerstoffdiffusion wirken. Diese Wirkung ist mit einer einfachen TiN-Schicht nicht zu erreichen, weshalb in der Technik bisher beispielsweise ein Schichtsystem TiN-Ru verwendet wird. Gemäß der vorliegenden Erfindung kann als diese Diffusionsbarriere eine TiN-TiP-Schicht vorteilhaft eingesetzt werden.

Weiterhin wird der Kontakt zwischen dem dielektrischen Material, beispielsweise BST (BST = Barium-Strontium-Titanat), und der Metallisierung benötigt. Auch hier kann das erfindungsgemäße Schichtsystem TiN-TiP vorteilhaft Anwendung finden.

Die vorliegende Erfindung schafft somit ein Verfahren zur Herstellung von TiP/TiN-Doppelschichten, wobei die Bildung der TiP-Schicht innerhalb des bei der Mehrlagenmetallisierung von Halbleitern erlaubten Temperaturbereichs erfolgt. Die erzeugte Doppelschicht eignet sich hervorragend als Diffusionsbarriere zwischen einem Halbleiter, beispielsweise Silizium, und einer Metallisierung, beispielsweise Aluminium, sowie als Diffusionsbarriere zwischen Dielektrika oder Ferroelektrika und einer Kontaktschicht.

## Patentansprüche

1. Verfahren zum Erzeugen einer Titanmonophosphid-Schicht (TiP-Schicht) mit folgenden Schritten:

   a) Einbringen eines Trägers (12) in einen Reaktor (14);

   b) Abscheiden einer TiN-Schicht auf dem Träger (12) durch Zuführung von $TiCl_4$ und $NH_3$ in den Reaktor (14); und

   c) Tempern der TiN-Schicht unter Zuführung von $PH_3$ in den Reaktor (14) unmittelbar nach dem Abscheiden der TiN-Schicht zum Bilden der Titanmonophosphid-Schicht auf der TiN-Schicht.

2. Verfahren gemäß Anspruch 1, bei dem der Träger eine Siliziumscheibe ist.

3. Verfahren gemäß Anspruch 1 oder 2, bei dem die Schritte b) und c) bei einer Temperatur von maximal 450°C erfolgen.

4. Verfahren gemäß einem der Ansprüche 1 bis 3, bei dem die Schritte b) und c) bei einem Basisdruck zwischen $0,5 \times 10^{-3}$ und $5 \times 10^{-3}$ Pa, und vorzugsweise bei $2 \times 10^{-3}$ Pa, erfolgen.

5. Verfahren gemäß einem der Ansprüche 1 bis 4, bei dem im Schritt b) das $TiCl_4$ verdünnt in $N_2$ über eine Gasdusche (16) des Reaktors (14) und das $NH_3$ verdünnt in $N_2$ über eine Ringleitung (18) des Reaktors (14) eingebracht wird.

6. Verfahren gemäß Anspruch 5, bei dem das Verhältnis von $TiCl_4$ zu $N_2$ bei der Zuführung über die Gasdusche (16) zwischen 1:60 und 1:100, und vorzugsweise 1:80 beträgt, und bei dem das Verhältnis von $NH_3$ zu $N_2$ bei der Zuführung über die Ringleitung zwischen 1:5 und 1:9, und vorzugsweise 1:7, beträgt.

7. Verfahren gemäß einem der Ansprüche 1 bis 6, bei dem $PH_3$ im Schritt c) verdünnt in Argon über eine Ringleitung (18) des Reaktors (14) zugeführt wird.

8. Verfahren gemäß Anspruch 7, bei dem das Verhältnis $PH_3$ zu Argon zwischen 1:3 und 1:8, und vorzugsweise 1:5,77, beträgt.

9. Diffusionsbarriereschicht zwischen einem Halbleitermaterial, einem Dielektrikum oder einem Ferromagnetikum und einer auf dasselbe aufgebrachten Metallisierung, bestehend aus einer Doppelschicht, die eine TiN-Schicht und eine TiP-Schicht aufweist.

**10.** Verwendung einer Diffusionsbarriereschicht zwischen einem Dielektrikum oder einem Ferromagnetikum und einer auf dasselbe aufgebrachten Metallisierung nach Anspruch 9 in einem DRAM-Bauelement.

**Claims**

**1.** A method for producing a titanium monophosphide layer (TiP layer) comprising the following steps:

> a) placing a carrier (12) in a reactor (14);
>
> b) depositing a TiN layer on the carrier (12) by supplying $TiCl_4$ and $NH_3$ to the reactor (14); and
>
> c) annealing the TiN layer while supplying $PH_3$ to the reactor (14) immediately after deposition of the TiN layer, so as to form the titanium monophosphide layer on the TiN layer.

**2.** The method of claim 1, wherein the carrier is a silicon wafer.

**3.** The method of claim 1 or 2, wherein steps b) and c) are carried out at a temperature of 450 °C at maximum.

**4.** The method of any of claims 1 to 3, wherein steps b) and c) are carried out at a base pressure between $0.5 \times 10^{-3}$ and $5 \times 10^{-3}$ Pa and preferably at $2 \times 10^{-3}$ Pa.

**5.** The method of any of claims 1 to 4, wherein in step b) the $TiCl_4$ is introduced diluted in $N_2$ via a gas shower (16) of the reactor (14) and the $NH_3$ is introduced diluted in $N_2$ via a ring channel (18) of the reactor (14).

**6.** The method of claim 5, wherein the ratio of $TiCl_4$ to $N_2$ in the supply via the gas shower (16) is between 1:60 and 1:100 and preferably 1:80, and wherein the ratio of $NH_3$ to $N_2$ in the supply via the ring channel is between 1:5 and 1:9 and preferably 1:7.

**7.** The method of any of claims 1 to 6, wherein PH3 in step c) is supplied diluted in argon via a ring channel (18) of the reactor (14).

**8.** The method of claim 7, wherein the ratio $PH_3$ to argon is between 1:3 and 1:8 and preferably 1:5.77.

**9.** A diffusion barrier layer between a semiconductor material, a dielectric or a ferromagnetic material and a metallization deposited thereon, consisting of a bilayer comprising a TiN layer and a TiP layer.

**10.** The use of a diffusion barrier layer between a dielectric or a ferromagnetic material and a metallization deposited thereon, according to claim 9, in a DRAM component element.

**Revendications**

**1.** Procédé pour produire une couche de monophosphure de titane (couche de TiP) aux étapes suivantes consistant à :

> a) Introduire un support (12) dans un réacteur (14) ;
> b) déposer une couche de TiN sur le support (12), par alimentation de $TiCl_4$ et de $NH_3$ dans le réacteur (14) ; et
>
> tremper la couche de TiN, avec alimentation de $PH_3$ dans le réacteur (14), immédiatement après le dépôt de la couche de TiN, pour former la couche de monophosphure de titane sur la couche de TiN.

**2.** Procédé suivant la revendication 1, dans lequel le support est une plaquette en silicium.

**3.** Procédé suivant la revendication 1 ou 2, dans lequel les étapes b) et c) ont lieu à une température de maximum 450°C.

**4.** Procédé suivant l'une des revendications 1 à 3, dans lequel les étapes b) et c) ont lieu à une pression de base comprise entre $0,5 \times 10^{-3}$ et $5 \times 10^{-3}$ Pa et, de préférence, à $2 \times 10^{-3}$ Pa.

**5.** Procédé suivant l'une des revendications 1 à 4, dans lequel, à l'étape b), le $TiCl_4$ est alimenté, dilué dans $N_2$, par une douche à gaz (16) du réacteur (14) et le $NH_3$, dilué dans $N_2$, par une conduite annulaire (18) du réacteur (14).

**6.** Procédé suivant la revendication 5, dans lequel le rapport entre $TiCl_4$ et $N_2$ lors de l'alimentation par la douche à gaz (16) est compris entre 1:60 et 1:100 et est, de préférence, 1:80.

**7.** Procédé suivant l'une des revendications 1 à 6, dans lequel $pH_3$ est alimenté à l'étape c), dilué dans de l'argon, par une conduite annulaire (18) du réacteur (14).

**8.** Procédé suivant la revendication 7, dans lequel le rapport entre $pH_3$ et argon est compris entre 1:3 et 1:8 et est, de préférence, 1:5,77.

9. Couche barrière de diffusion entre un matériau semi-conducteur, un diélectrique ou un ferromagnétique et une métallisation appliquée sur celui-ci, consistant en une double couche présentant une couche de TiN et une couche de TiP.

10. Utilisation d'une couche barrière de diffusion entre un diélectrique ou un ferromagnétique et une métallisation appliquée sur celui-ci, suivant la revendication 9, dans un composant DRAM.

*FIG.1*

*FIG.2*